Europäisches Patentamt

European Patent Office

Office européen des brevets

(11) Publication number: **0 347 194**
A2

# EUROPEAN PATENT APPLICATION

(21) Application number: 89306001.2

(22) Date of filing: 14.06.89

(51) Int. Cl.⁴: **G 11 C 17/00**

(30) Priority: 15.06.88 JP 147771/88

(43) Date of publication of application:
20.12.89 Bulletin 89/51

(84) Designated Contracting States: DE FR GB

(71) Applicant: SEIKO INSTRUMENTS INC.
31-1, Kameido 6-chome Koto-ku
Tokyo 136 (JP)

(72) Inventor: Ueda, Chiharu c/o Seiko Instruments Inc.
31-1 Kameido 6-chome Koto-ku
Tokyo (JP)

(74) Representative: Caro, William Egerton et al
J. MILLER & CO. Lincoln House 296-302 High Holborn
London WC1V 7JH (GB)

(54) Non-volatile semi-conductor memory device.

(57) A non-volatile semi-conductor memory device comprises a
memory cell array (9) comprised of memory cells, the array (9)
being capable of writing and erasing data electrically, an
address de-coder (2) responsive to addresses for selecting
memory cells, a read/write circuit (3) for reading data stored in
memory cells and for writing data to memory cells, a control
circuit (1) responsive to a control input signal for controlling the
address de-coder (2) and the read/write circuit (3) and a write
protection circuit (5) having an external input terminal (6). The
write protection circuit is arranged to protect a specific region
of the memory cell array (9) from being written by fixing a
potential of the external input terminal (6).

F I G. 1

EP 0 347 194 A2

## Description

## NON-VOLATILE SEMI-CONDUCTOR MEMORY DEVICE

This invention relates to non-volatile semi-conductor memory devices.

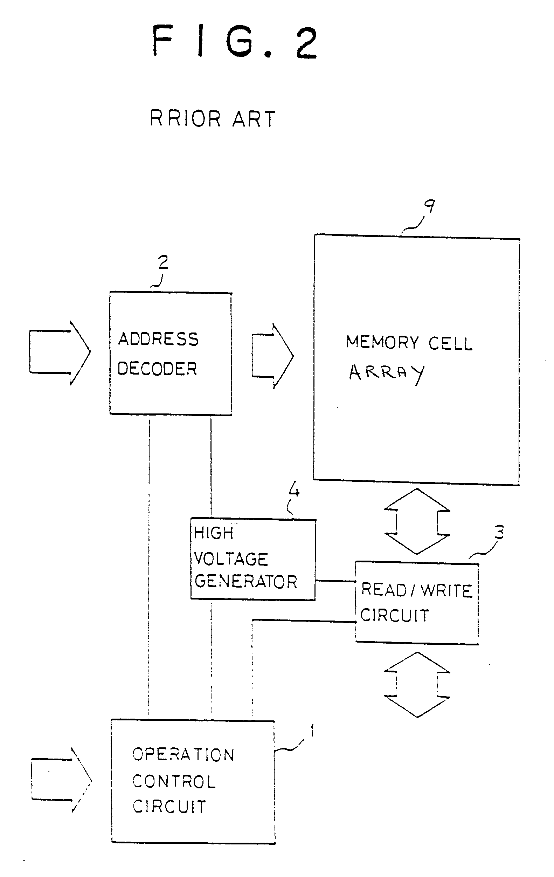

In recent years, it has become possible to fabricate a semi-conductor non-volatile memory device which can be written using a single operational power source. In such a semi-conductor non-volatile memory device, the writing operation can be accomplished with an input signal at the level of the operational power source without requiring any special external high voltage source. Generally speaking, in an electrically programmable semi-conductor non-volatile memory device, write and read operations are controlled by one or more control input signals, by their combination or by their ordered combination. This known control is accomplished commonly for any regions of a memory cell array of a semi-conductor non-volatile memory device, as shown in Figure 2. In Figure 2: reference numeral 1 designates an operation control circuit; reference numeral 2 designates an address decoder; reference numeral 3 designates a write/read circuit; reference numeral 4 designates a high voltage generator; and reference numeral 9 designates a memory cell array.

When a common system handles at least two kinds of data to be frequently written and not to be written, the data is stored in a common semi-conductor non-volatile memory device during the fabrication of or before the shipping of the system. In this case, the known semi-conductor non-volatile memory device has the defect that important data may be over-written by an erroneous write operation which is caused either by noise fed to a control input or by an unexpected input signal such as caused by run away of a CPU controlling the semi-conductor non-volatile memory device.

The present invention seeks to provide a non-volatile semi-conductor memory device which prevents inadvertent storing of unknown data in a specific memory cell region, i.e. can maintain data which it is desired not to over-write even in the presence of an unexpected input signal.

According to the present invention, there is provided a non-volatile semi-conductor memory device characterised by comprising: a memory cell array comprised of a plurality of memory cells, the memory cell array being capable of writing and erasing data electrically; address de-coder means responsive to addresses for selecting memory cells; read/write means for reading data stored in memory cells and for writing data to memory cells; control means responsive to a control input signal for controlling the address de-coder means and the read/write means; and write protection means having an external input terminal, the write protection means being arranged, in operation, to protect a specific region of the memory cell array from being written by fixing a potential of the external input terminal.

Preferably the memory device has high voltage generating means responsive to a signal from the control means for generating a relatively high voltage signal and for supplying the relatively high voltage signal to the read/write means and the address de-coder means. The high voltage generating means may be connected to the memory cell array.

In one embodiment the memory cell array comprises a random access memory unit and an electrically erasable programmable read only memory unit, each random access memory cell corresponding to each electrically erasable programmable read only memory cell. Thus preferably store/re-call control means responsive to a control input signal for storing in the electrically erasable programmable read only memory unit the data of the random access memory unit for re-calling the data of the electrically erasable programmable read only memory unit to the random access memory unit.

In another embodiment the memory cell array comprises an electrically erasable programmable read only memory.

The invention is illustrated, merely by way of example, in the accompanying drawings, in which:-

Figure 1 is a block diagram of a first embodiment of a semi-conductor non-volatile memory device according to the present invention;

Figure 2 is a block diagram of a semi-conductor non-volatile memory device of the prior art; and

Figure 3 is a block diagram of a second embodiment of a semi-conductor non-volatile memory device according to the present invention.

According to the present invention, a semi-conductor non-volatile memory device is equipped with an external input terminal which has its potential fixed at the end of a write operation to prevent a memory cell in a specific region of a memory cell array of the semi-conductor non-volatile memory device from being written or over-written.

In a system using a semi-conductor non-volatile memory device according to the present invention, the specific region of the memory cell array, which is protected against being written by the external input terminal, is written by an operation control circuit whilst holding the external input terminal at one of a plurality of input signal levels. At the end of the write operation, the external input terminal is fixed at another of the input signal levels by connecting it to the interior of the semi-conductor non-volatile memory device or to a system outside the memory device, thereby to inhibit the writing of the specific region of the memory cell array of the semi-conductor non-volatile memory device.

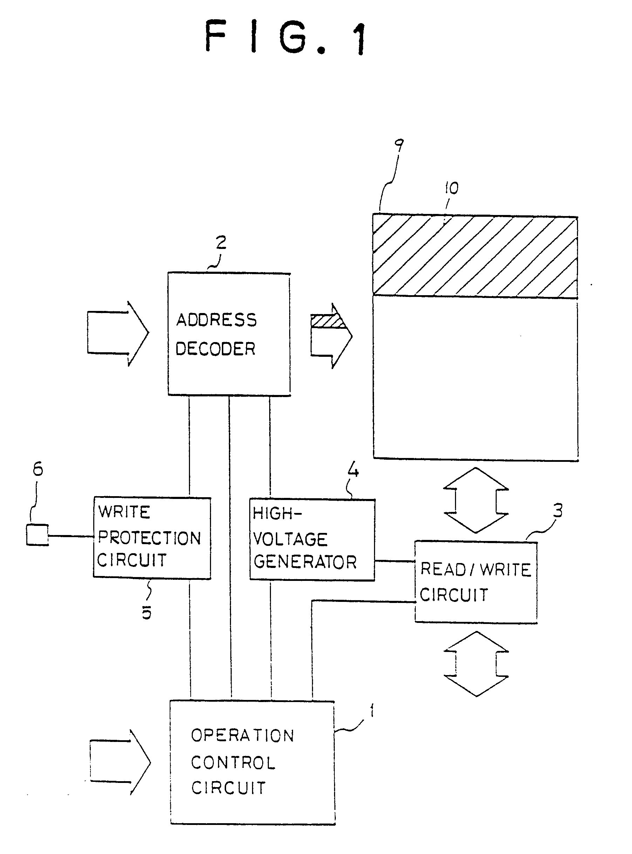

An electrically erasable PROM according to the present invention will be described with reference to Figure 1. A operation control circuit 1 is connected with an address de-coder 2 containing a high voltage switch (not shown), a write/read circuit 3 containing a high voltage switch (not shown), a high voltage generator 4, and a write protection circuit 5. The high voltage generator 4 is connected with the address de-coder 2 and the write/read circuit 3. The address de-coder 2 and the write/read circuit 3 are both connected with a memory cell array 9. The write protection circuit 5 is connected with not only an external input terminal 6 but also the address de-coder 2. First of all, in the case where initial data, which it is not desired to erase, is to be written, the function of the write protection circuit 5 for preventing inadvertent storage of unknown data in a region 10 is released from the external input terminal 6 so that the write protected region 10 may be selected for a write operation by the address de-coder 2. Next, in the case where the semi-conductor non-volatile memory device is to be used, the external input terminal 6 is fixed to perform a write protecting function. Then, even if there arises an input state for causing a re-write operation in the write protected region 10, this region 10 is not fed with such a high voltage as to make the re-write possible from the write protection circuit 5 so that the aforementioned initial data is not over-written but protected.

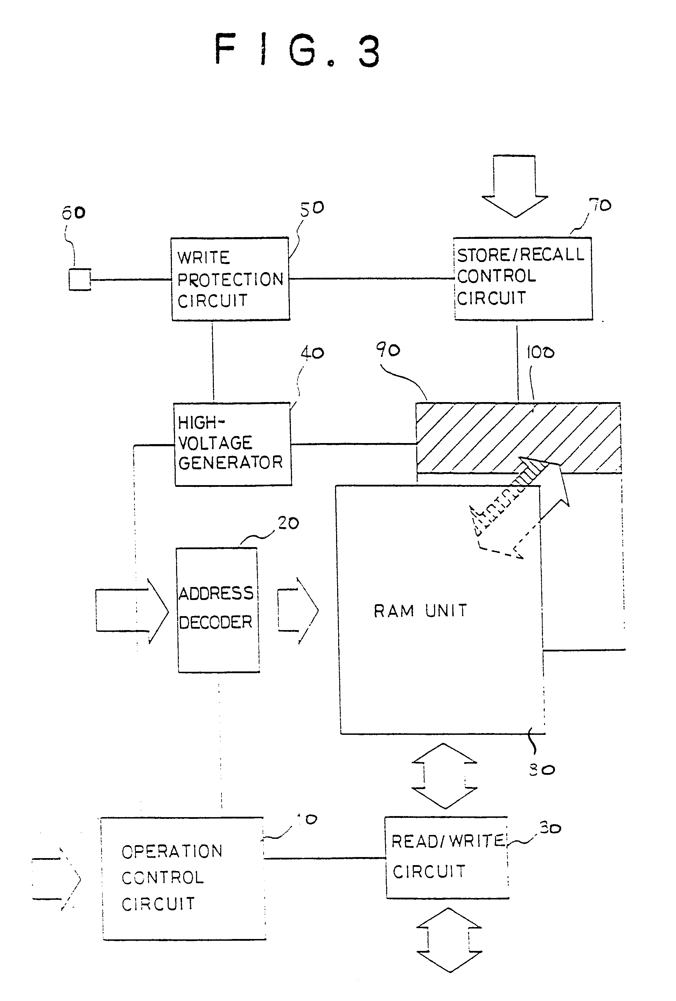

As electrically erasable non-volatile RAM according to the present invention will now be described with reference to Figure 3. An operation control circuit 10 is connected with a write/read circuit 30 and a high voltage generator 40. A PROM unit 90 is connected not only with a RAM unit 80 in a bit corresponding manner but also with the high voltage generator 40 and a store/re-call control circuit 70. An address de-coder 20 and the write/read circuit 30 are connected with the RAM unit 80. A write protection circuit 50 is connected with not only an external input terminal 60 but also the high voltage generator 40 and the store/re-call control circuit 70.

First, in the case where initial data, which it is not desired to erase, is to be written in the PROM unit 90, the function of protecting the re-writing of a write protected region 100 of the PROM unit 90 is released from the external input terminal 60, and the data is written in the portion of the RAM unit 80 corresponding to the write protected region 100. The non-volatile write operation (which will be referred to as a "store operation") in the PROM unit 90 is accomplished by controlling the data stored in the RAM unit 80 by the store/re-call control circuit 70. At this time, all the data in the RAM unit 80 is written in the PROM unit 90. In the case where the data written in the PROM unit 90 is to be read out, all the data stored in the PROM unit 90 is read out (referred to as a "re-call operation") to the RAM unit 80 under the control of the store/re-call control circuit 70 so that the data of the RAM unit 80 may be read out by the control of the operation control circuit 10. Next, the external input terminal 60 is fixed to satisfy the write protecting function and the data stored in the RAM unit 80 is stored and written in the PROM unit 90. In this case, the storing operation from the RAM unit 80 to the PROM unit 90 is not accomplished for the write protected region 100, thus maintaining the initial data.

As has been described hereinbefore, an electrically erasable programmable semi-conductor non-volatile memory device according to the present invention is able to protect data which it is not desired to over-write but is allowed to accomplish a non-volatile re-write operation on the system whilst enjoying intrinsic convenience. In other words, the two applications of a read only memory and a re-write memory can be satisfied by a single semi-conductor non-volatile memory device, thus giving high advantage as far as cost performance and simple development of software for a system are concerned. Another advantage is that an erroneous write operation due to noise in the system and run away of the CPU can be prevented by giving a system higher safety.

## Claims

1. A non-volatile semi-conductor memory device characterised by comprising: a memory cell array (9; 80, 90) comprised of a plurality of memory cells, the memory cell array (9; 80, 90) being capable of writing and erasing data electrically; address de-coder means (2; 20) responsive to addresses for selecting memory cells; read/write means (3; 30) for reading data stored in memory cells and for writing data to memory cells; control means (1; 10) responsive to a control input signal for controlling the address de-coder means (2; 20) and the read/write means (3; 30); and write protection means (5; 50) having an external input terminal (6; 60), the write protection means being arranged, in operation, to protect a specific region of the memory cell array (9; 80, 90) from being written by fixing a potential of the external input terminal (6; 60).

2. A memory device as claimed in claim 1 characterised by high voltage generating means (4; 40) responsive to a signal from the control means (1; 10) for generating a relatively high voltage signal and for supplying the relatively high voltage signal to the read/write means (3; 30) and the address de-coder means (2; 20).

3. A memory device as claimed in claim 2 characterised in that the high voltage generating means (4; 40) are connected to the memory cell array (9; 80, 90).

4. A memory device as claimed in any preceding claim characterised in that the memory cell array comprises a random access memory unit (80) and an electrically erasable programmable read only memory unit (90), each random access memory cell corresponding to each electrically erasable programmable read only memory cell.

5. A memory device as claimed in claim 4 characterised by store/re-call control means (70) responsive to a control input signal for storing in the electrically erasable programmable read only memory unit (90) the data of the random access memory unit (80) for re-calling the data of the electrically erasable programmable read only memory unit (90) to the random access memory unit (80).

6. A memory device as claimed in any of claims 1 to 3 characterised in that the memory cell array comprises an electrically erasable programmable read only memory (9).

# F I G. 1

ADDRESS DECODER

WRITE PROTECTION CIRCUIT

HIGH-VOLTAGE GENERATOR

READ / WRITE CIRCUIT

OPERATION CONTROL CIRCUIT

# FIG. 2

RRIOR ART

ADDRESS DECODER

MEMORY CELL ARRAY

HIGH VOLTAGE GENERATOR

READ / WRITE CIRCUIT

OPERATION CONTROL CIRCUIT

# F I G . 3